# EUROPEAN PATENT APPLICATION

(11) **EP 4 191 221 A1**
(43) Date of publication of application: **07.06.2023**
(21) Application number: 21857186.7
(22) Date of filing: 08.04.2021
(51) Int. Cl.: G01M 17/007, G05B 17/02, G06F 30/20

(54) **VEHICLE SIMULATION TEST SCENARIO CONSTRUCTION METHOD AND DEVICE**

(30) Priority: 21.08.2020 CN 202010850861
(71) Applicant: Huawei Technologies Co., Ltd., Longgang Shenzhen, Guangdong 518129 (CN)
(72) Inventor: ZHANG, Xiaoyu, Shenzhen, Guangdong 518129 (CN); QIN, Li, Shenzhen, Guangdong 518129 (CN)
(74) Representative: Thun, Clemens
(86) International application number: PCT/CN2021/085990
(87) International publication number: WO 2022/037085

(57) **Abstract**

A method and an apparatus for constructing a vehicle simulation test scenario are provided, so that simulation test scenarios can be provided for an intelligent vehicle, a self-driving vehicle, and a connected vehicle. The foregoing method includes: after a first entity is selected from an ontology model based on a to-be-tested task, automatically selecting one or more second entities associated with the first entity from the ontology model based on a preset entity association relationship in the ontology model; and constructing a simulation test scenario based on the selected first entity and the selected one or more second entities. This avoids a case in the conventional technology of missing entities or selecting extra entities in a process of manually selecting an entity by test personnel to construct a simulation test scenario, and helps improve accuracy of constructing a simulation test scenario.

## Description

This application claims priority to Chinese Patent Application No. 202010850861.4, filed with the China National Intellectual Property Administration on August 21, 2020 and entitled "METHOD AND APPARATUS FOR CONSTRUCTING VEHICLE SIMULATION TEST SCENARIO", which is incorporated herein by reference in its entirety.

### TECHNICAL FIELD

This application relates to the self-driving field, and more specifically, to a method and an apparatus for constructing a vehicle simulation test scenario.

### BACKGROUND

In a case of a road test, a proportion of driver errors increases with accumulation of test distances. In addition, a plurality of extreme dangerous scenarios are not suitable for real-person operations. Therefore, a simulation test is better than the road test because of limitations of the road test, such as high test costs, a long test period, and a large quantity of test accidents. In a case of the simulation test, construction costs of a simulation scenario library are low, and the simulation scenario library is not restricted by a weather condition, a region condition, or the like, thus, personal and property injuries are effectively avoided, and the simulation test focuses more on human-vehicle-environment interaction. In addition, the simulation test combines a real hardware system with a simulation environment to form a test tool chain, to use advantages of the simulation environment, such as infinity, scalability, batching, and automation, and implement rapid deployment and automatic testing of a simulation test scenario.

Construction of a vehicle simulation test scenario is one of hot issues in the current research. Currently, the conventional technology proposes a method for constructing a simulation test scenario based on an ontology model. In the method, various entities are provided in the ontology model to represent traffic elements in a road traffic scenario, for example, an obstacle entity that describes an obstacle that may be encountered in a driving process of a vehicle, and a road network entity that describes a road on which the vehicle travels. The road network entity may further include a region entity and a point entity. The region entity further includes a lane entity, a lane line entity, a crosswalk entity, and the like, and the point entity may further include a traffic light entity, a traffic sign entity, a stop line entity, and the like. Test personnel need to select an appropriate entity from thousands of entities provided in the ontology model based on a road traffic scenario corresponding to a to-be-tested task, to construct a simulation test scenario in the ontology model.

However, because there are a relatively large quantity of entities provided in the ontology model, the test personnel usually select an entity based on previous experience. Different test personnel may select different entities, and there may be a case of missing entities or selecting extra entities. Consequently, the constructed simulation test scenario is inaccurate, and a simulation test result of the vehicle is affected.

### SUMMARY

This application provides a method and an apparatus for constructing a vehicle simulation test scenario, so as to improve accuracy of creating a simulation test scenario in an ontology model.

According to a first aspect, a method for constructing a vehicle simulation test scenario is provided, including: obtaining a to-be-tested task, where the to-be-tested task is used to indicate to test a function of a target vehicle, and/or test a driving scenario in which the target vehicle travels; selecting a first entity from a preset ontology model based on the to-be-tested task, where the ontology model includes a plurality of entities used to describe traffic elements; selecting one or more second entities associated with the first entity from the ontology model based on the first entity and a preset entity association relationship, where the entity association relationship represents a relationship between entities in the ontology model; and constructing, based on the first entity and the one or more second entities, a simulation test scenario used to test the to-be-tested task.

In this embodiment of this application, after the first entity is selected from the ontology model based on the to-be-tested task, the one or more second entities associated with the first entity are automatically selected from the ontology model based on the preset entity association relationship in the ontology model; and the simulation test scenario is constructed based on the selected first entity and the selected one or more second entities. This avoids a case in the conventional technology of missing entities or selecting extra entities in a process of manually selecting an entity by test personnel to construct a simulation test scenario, and helps improve accuracy of constructing a simulation test scenario.

In a possible implementation, the selecting one or more second entities associated with the first entity from the ontology model based on the first entity and a preset entity association relationship includes: selecting the one or more second entities from the ontology model based on the first entity, the entity association relationship, and a preset entity association degree, where the entity association degree represents a degree of association between entities in the ontology model, a degree of association between each of the one or more second entities and the first entity is higher than a degree of association between another entity in the ontology model and the first entity, and the another entity is an entity other than the second entity in the ontology model.

In this embodiment of this application, the one or more second entities are selected from the ontology model based on the preset entity association degree. This helps limit a quantity of selected second entities, so as to reduce a calculation amount occupied when a simulation test is performed on the to-be-tested task.

In a possible implementation, before the selecting the one or more second entities from the ontology model based on the first entity, the entity association relationship, and a preset entity association degree, the method further includes: obtaining an association degree threshold based on the to-be-tested task, where the association degree threshold is an association degree threshold used for selecting the one or more second entities from the ontology model; and the selecting the one or more second entities from the plurality of entities based on the first entity, the entity association relationship, and a preset degree of association between entities includes: selecting the one or more second entities from the ontology model based on the first entity, the entity association relationship, and the entity association degree, where the degree of association between the first entity and each of the one or more second entities is higher than the association degree threshold.

In this embodiment of this application, the one or more second entities are selected from the ontology model based on the association degree threshold. This helps more properly select the second entity.

In a possible implementation, the constructing, based on the first entity and the one or more second entities, a simulation test scenario used to test the to-be-tested task includes: creating a first instance of the first entity and one or more second instances of the one or more second entities in the ontology model based on an attribute of the first entity, an attribute of the second entity, and a relationship between the first entity and the second entity; and constructing the simulation test scenario in the ontology model based on the first instance and the one or more second instances.

In this embodiment of this application, the simulation test scenario is constructed in the ontology model based on the first instance and the second instance. This helps improve accuracy of constructing the simulation test scenario.

In a possible implementation, before the creating a first instance of the first entity and one or more second instances of the one or more second entities in the ontology model based on an attribute of the first entity, an attribute of the second entity, and a relationship between the first entity and the second entity, the method further includes: obtaining the attribute of the first entity, the attribute of the second entity, and the relationship between the first entity and the second entity.

In this embodiment of this application, the first instance and the second instance are created by obtaining the attribute of the first entity, the attribute of the second entity, and the relationship between the first entity and the second entity. This helps more properly create the first instance and the second instance.

In a possible implementation, the selecting a first entity from a preset ontology model based on the to-be-tested task includes: obtaining information used to describe content of the to-be-tested task, where the information includes a first traffic element; and selecting the first entity from the preset ontology model based on the first traffic element, where the first entity is used to describe the first traffic element.

In this embodiment of this application, the first entity is selected based on the information used to describe the content of the to-be-tested task. This helps improve automation of selecting the first entity.

According to a second aspect, a method for constructing a vehicle simulation test scenario is provided, including: selecting a first entity from a preset ontology model based on a to-be-tested task, where the to-be-tested task is used to indicate to test a to-be-tested function of a target vehicle, and/or test a to-be-tested driving scenario in which the target vehicle travels, and the ontology model includes a plurality of entities used to describe traffic elements; selecting one or more second entities associated with the first entity from the ontology model based on the first entity and a preset entity association relationship, where the entity association relationship represents a relationship between entities in the ontology model; and updating a constructed first simulation test scenario in the ontology model based on the first entity and the one or more second entities, to obtain a second simulation test scenario in the ontology model, where the first simulation test scenario and the second simulation test scenario are simulation test scenarios used to test the to-be-tested task.

In this embodiment of this application, the one or more second entities are selected from the ontology model based on the first entity and the entity association relationship, to update the first simulation test scenario, to obtain the second simulation test scenario. This helps improve accuracy of constructing the second simulation test scenario.

In addition, the method in this embodiment of this application is combined with a conventional simulation scenario construction method, that is, the first simulation test scenario obtained according to the conventional simulation scenario construction method is updated, to obtain the second simulation test scenario. This helps improve compatibility of the simulation scenario construction method in this embodiment of this application.

In a possible implementation, the selecting one or more second entities associated with the first entity from the ontology model based on the first entity and a preset entity association relationship includes: selecting the one or more second entities associated with the first entity based on the first entity, the entity association relationship, and an entity association degree, where the entity association degree is used to represent a degree of association between entities in the ontology model, a degree of association between each of the one or more second entities and the first entity is higher than a degree of association between another entity and the first entity, and the another entity is an entity other than the second entity in the plurality of entities.

In this embodiment of this application, the one or more second entities are selected from the ontology model based on the preset entity association degree. This helps limit a quantity of selected second entities, so as to reduce a calculation amount occupied when a simulation test is performed on the to-be-tested task.

In a possible implementation, the updating a constructed first simulation test scenario in the ontology model based on the first entity and the one or more second entities, to obtain a second simulation test scenario includes: matching entities to which instances in the first simulation test scenario belong against the first entity and the one or more second entities, to determine an entity that is not included in the first simulation test scenario; creating, in the ontology model, an instance corresponding to the entity that is not included; and adding the instance corresponding to the entity that is not included to the first simulation test scenario, to obtain the second simulation test scenario.

In this embodiment of this application, the first entity and the one or more second entities are compared with the entities in the first simulation test scenario, to obtain the entity that is not included in the first simulation test scenario, and the entity that is not included is added to the first simulation test scenario, to obtain the second simulation test scenario. This helps improve accuracy of constructing the second simulation test scenario.

In a possible implementation, the updating a constructed first simulation test scenario in the ontology model based on the first entity and the one or more second entities, to obtain a second simulation test scenario includes: matching entities in the first simulation test scenario against the first entity and the one or more second entities, to determine a redundant entity other than the first entity and the one or more second entities in the first simulation test scenario; and deleting an instance corresponding to the redundant entity from the first simulation test scenario, to obtain the second simulation test scenario

In this embodiment of this application, the first entity and the one or more second entities are compared with the entities in the first simulation test scenario, to obtain the redundant entity included in the first simulation test scenario, and the redundant entity is deleted from the first simulation test scenario, to obtain the second simulation test scenario. This helps improve accuracy of constructing the second simulation test scenario.

According to a third aspect, an apparatus for constructing a vehicle simulation test scenario is provided. The apparatus includes units used for the methods in the foregoing aspects.

According to a fourth aspect, an apparatus for constructing a vehicle simulation test scenario is provided. The apparatus has functions of implementing the apparatus in the method designs in the foregoing aspects. These functions may be implemented by hardware, or may be implemented by hardware by executing corresponding software. The hardware or the software includes one or more units corresponding to the foregoing functions.

According to a fifth aspect, a computing device is provided, including an input/output interface, a processor, and a memory. The processor is configured to control the input/output interface to send and receive a signal or information, the memory is configured to store a computer program, and the processor is configured to invoke the computer program from the memory and run the computer program, so that the computing device performs the methods in the foregoing aspects.

According to a sixth aspect, a computer program product is provided. The computer program product includes computer program code, and when the computer program code is run on a computer, the computer is enabled to perform the methods in the foregoing aspects.

It should be noted that all or a part of the foregoing computer program code may be stored on a first storage medium. The first storage medium may be encapsulated together with a processor, or may be encapsulated separately from a processor. This is not specifically limited in this embodiment of this application.

According to a seventh aspect, a computer-readable medium is provided. The computer-readable medium stores program code, and when the computer program code is run on a computer, the computer is enabled to perform the methods in the foregoing aspects.

According to an eighth aspect, a chip system is provided. The chip system includes a processor, which is used by a computing device to implement functions in the foregoing aspects, for example, generate, receive, send, or process data and/or information in the foregoing methods. In a possible design, the chip system further includes a memory. The memory is configured to store program instructions and data that are necessary for a computing device. The chip system may include a chip, or may include a chip and another discrete component.

### BRIEF DESCRIPTION OF DRAWINGS

FIG. 1 is a schematic diagram of a simulation test system to which an embodiment of this application is applicable;
FIG. 2 is a schematic diagram of an architecture of an ontology model according to an embodiment of this application;
FIG. 3 is a flowchart of a method for constructing a vehicle simulation test scenario according to an embodiment of this application;
FIG. 4 is a topology view of an association relationship between entities in an ontology model according to an embodiment of this application;
FIG. 5 is a flowchart of a method for constructing a vehicle simulation test scenario according to another embodiment of this application;
FIG. 6 is a schematic diagram of an apparatus for constructing a vehicle simulation test scenario according to an embodiment of this application;
FIG. 7 is a schematic diagram of an apparatus for constructing a vehicle simulation test scenario according to another embodiment of this application; and
FIG. 8 is a schematic block diagram of a computing device according to another embodiment of this application.

### DESCRIPTION OF EMBODIMENTS

The following describes technical solutions of this application with reference to accompanying drawings. For ease of understanding, terms in embodiments of this application are described first.
1. Ontology model: The ontology model may be understood as a real model obtained through abstraction according to a concept in real life, a relationship between concepts, a feature (that is, an attribute) of the concept, and an instance of the concept.
2. Ontology model: The ontology model may be understood as describing, by using the ontology model, a traffic element (that is, an entity), a class (that is, a concept) of the traffic element, a relationship between traffic elements, a feature (attribute) of the traffic element, and the like in a road traffic scenario.
3. Entity: The entity in the ontology model is used to describe a static traffic element and a dynamic traffic element in a real road traffic scenario, and is a basic element for constructing a simulation test scenario, for example, a lane entity, a lane line entity, a crosswalk entity, a traffic sign entity, a static obstacle entity, and a dynamic obstacle entity in the ontology model.
4. Class: The class may be considered as a set (sets), and is used to indicate a class of the entity in the ontology model. The ontology model usually includes an ego vehicle class, a road network class, an obstacle class, a behavior class, a driving environment class, and the like.

The ego vehicle class is used to describe an ego vehicle.

The road network class is used to describe a connection relationship between roads, and may include a region entity and a point entity. The region entity may include a lane entity, a lane line entity, a crosswalk entity, an intersection entity, a road section entity, and the like. The point entity may include a traffic light entity, a traffic sign entity, a stop line entity, a speed-limit sign entity, and the like.

The obstacle class is used to describe an obstacle entity encountered in a process in which the ego vehicle travels. The obstacle class may include a static obstacle class and a dynamic obstacle class. The static obstacle class may include a plurality of static obstacle entities, for example, a construction signboard entity and a water horse enclosure entity. The dynamic obstacle class may include a plurality of dynamic obstacle entities, for example, a pedestrian entity, a motor vehicle entity, and a non-motor vehicle entity.

The behavior class may be considered as a set of driving actions of the ego vehicle, for example, may include an acceleration entity, a deceleration entity, a constant-speed entity, a parking entity, a leftward lane change entity, a rightward lane change entity, an overtaking entity, and a confluence entity.

The driving environment class may be considered as a set describing a driving environment, for example, may include a weather entity, a temperature entity, a humidity entity, and a lighting condition entity.

5. Relationship: The relationship is used to describe a relationship between entities, and is a basis for determining whether to select an entity as a test variable (entity) in a simulation test scenario. For example, a relationship between an ego vehicle entity and a road 1 entity may be that the ego vehicle entity travels on the road 1. For another example, a relationship between a road section entity and an intersection entity may be that the road section entity is connected to the intersection entity.

6. Attribute (feature): The attribute is a specific state or parameter value of the entity or relationship. After an entity is selected from the ontology model as a test variable, the entity usually has a plurality of optional states or configurable parameter options. These optional states or configurable parameter options are attributes. For example, an attribute of the ego vehicle entity includes a speed attribute of the ego vehicle. For another example, an attribute of the motor vehicle entity includes a class of the motor vehicle, a speed of the motor vehicle, and coordinates of the motor vehicle. For another example, an attribute of the acceleration entity in the behavior class is a specific acceleration value. For another example, a state attribute of a relationship between different obstacle entities includes front, front left, left, rear left, rear, rear right, right, and front right. For another example, a state attribute of the weather entity includes sunny, rainy, and snowy.

7. Instance: Settings of the state and the parameter value determine input space of the instance in the simulation test scenario. Different input combinations generate different test cases, that is, instances.

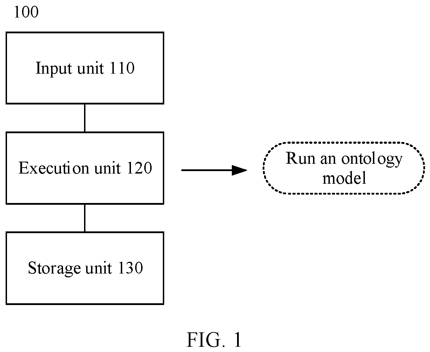

With reference to FIG. 1, the following describes a simulation test system to which an embodiment of this application is applicable. The simulation test system 100 shown in FIG. 1 includes an input unit 110, an execution unit 120, and a storage unit 130.

The input unit 110 is configured to obtain a to-be-tested task.

Optionally, the input unit 110 may be a user interface, configured to obtain information from a user of the simulation test system. Optionally, the input unit 110 may include one or more input/output devices, for example, a keyboard and a microphone.

The execution unit 120 is configured to: run simulation test software, and present an ontology model, to construct, in the ontology model, a simulation test scenario used to test the to-be-tested task.

Optionally, the execution unit 120 may be a processor, and specifically, may be any conventional processor, including a reduced instruction set computing (reduced instruction set computing, RISC) processor, a complex instruction set computing processor, or a combination thereof. Optionally, the processor may be a dedicated apparatus such as an application-specific integrated circuit (application-specific integrated circuit, ASIC).

The storage unit 130 is configured to store a running program of the simulation test software, data generated in a process of using the simulation test software, a simulation running result, or the like.

Optionally, the storage unit 130 may be a memory. The memory and the processor may be encapsulated into one chip, or the memory and the processor may be encapsulated into different chips. This is not limited in this embodiment of this application.

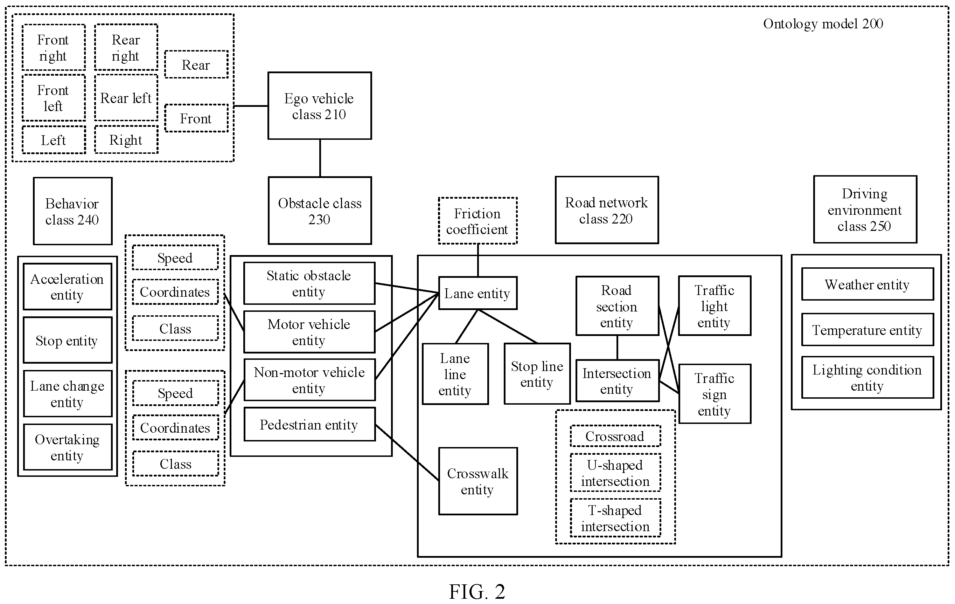

Based on the simulation system shown in FIG. 1, the following describes an ontology model in embodiments of this application with reference to FIG. 2. It should be noted that the ontology model in embodiments of this application may alternatively be in another architecture. This is not limited in embodiments of this application.

The ontology model 200 shown in FIG. 2 includes an ego vehicle class 220, a road network class 220, an obstacle class 230, a behavior class 240, and a driving environment class 250.

The ego vehicle class 220 includes an ego vehicle entity. After a corresponding speed and corresponding coordinates are set for the ego vehicle entity, an ego vehicle instance is generated.

The behavior class 240 includes an acceleration entity, a stop entity, a lane change entity, and an overtaking entity. An instance corresponding to an entity in the behavior class 240 may be generated by setting a parameter for the entity, to describe driving behavior of an ego vehicle.

The obstacle class 230 includes a static obstacle entity and a dynamic obstacle entity, and the dynamic obstacle entity includes a motor vehicle entity, a non-motor vehicle entity, and a pedestrian entity. A motor vehicle instance may be generated by setting a speed, coordinates, and a class of the motor vehicle entity. A non-motor vehicle instance may be generated by setting a speed, coordinates, and a class of the non-motor vehicle entity. In addition, in a process of instantiating an entity in the obstacle class, a relationship between an obstacle and an ego vehicle may be further set. For example, the ego vehicle entity is set to be located in one of the front, rear, front left, rear left, rear right, and front right of the entity in the obstacle class.

The road network class 230 includes a lane entity, a lane line entity, a crosswalk entity, a stop line entity, a road section entity, an intersection entity, a traffic light entity, and a traffic sign entity. A lane instance may be generated by setting a friction coefficient of the lane entity. An intersection instance may be created by setting the intersection entity to one of a crossroad, a U-shaped intersection, or a T-shaped intersection.

In a process of instantiating an entity in the road network class, a relationship between entities in the road network class may be further set. For example, the lane line entity is set to be located in the lane entity. For another example, the stop line entity is set to be located in the lane entity. For another example, the road section entity is set to be connected to the intersection entity. For another example, the traffic light entity is set to be located in the intersection entity. For another example, the traffic sign entity is set to be located in the intersection entity and the road section entity. For another example, the crosswalk entity is set to be located in the intersection entity.

In addition, in a process of instantiating an entity in the obstacle class, a relationship between an entity in the obstacle class and an entity in the road network class may be further set. For example, the motor vehicle entity, the non-motor vehicle entity, and the static obstacle entity may be set to be located in the lane entity. For another example, the pedestrian may be further set to be located in the crosswalk entity.

The driving environment class 250 includes a weather entity, a temperature entity, and a lighting condition entity. A weather instance, a temperature instance, and a lighting condition instance may be obtained by setting specific parameters of the weather entity, the temperature entity, and the lighting condition entity.

Currently, the conventional technology proposes a method for constructing a simulation test scenario based on an ontology model. In the method, various entities are provided in the ontology model to represent traffic elements in a road traffic scenario, for example, an obstacle entity that describes an obstacle that may be encountered in a driving process of a vehicle, and a road network entity that describes a road on which the vehicle travels. The road network entity may further include a region entity and a point entity. The region entity further includes a lane entity, a lane line entity, a crosswalk entity, and the like, and the point entity may further include a traffic light entity, a traffic sign entity, a stop line entity, and the like. Test personnel need to select an appropriate entity from thousands of entities provided in the ontology model based on a road traffic scenario corresponding to a to-be-tested task, to construct a simulation test scenario of the road traffic scenario in the ontology model.

However, because there are a relatively large quantity of entities provided in the ontology model, the test personnel usually select an entity based on experience. Different test personnel may select different entities, and there may be a case of missing entities or selecting extra entities. Consequently, the constructed simulation test scenario is inaccurate, and a simulation test result of the vehicle is affected.

To avoid the foregoing problem, this application provides a new method for constructing a simulation test scenario. To be specific, after a first entity is selected from an ontology model based on a to-be-tested task, one or more second entities associated with the first entity are automatically selected from a plurality of entities based on an entity association relationship in the ontology model; and a simulation test scenario is constructed based on the selected first entity and the selected one or more second entities. This avoids a case in the conventional technology of missing entities or selecting extra entities in a process of manually selecting an entity by test personnel to construct a simulation test scenario, and helps improve accuracy of constructing a simulation test scenario.

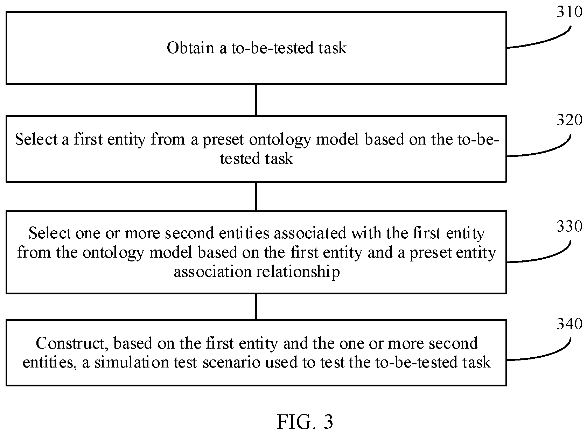

With reference to FIG. 3, the following describes a method for constructing a vehicle simulation test scenario according to an embodiment of this application. It should be understood that the method shown in FIG. 3 may be performed by the simulation test system shown in FIG. 1, or may be performed by another simulation test device, or may be performed by a computing device having a computing function. This is not specifically limited in this embodiment of this application. The method shown in FIG. 3 includes step 310 to step 340.

310: Obtain a to-be-tested task, where the to-be-tested task is used to indicate to test a to-be-tested function of a target vehicle (that is, the foregoing ego vehicle), and/or test a to-be-tested driving scenario in which the target vehicle travels.

The to-be-tested function of the target vehicle may include: testing a specific function of the target vehicle. For example, the to-be-tested function of the target vehicle may be a target recognition function of the target vehicle. For another example, the to-be-tested function of the target vehicle may alternatively be a lane change driving function. For another example, the to-be-tested function of the target vehicle may alternatively be a lane keeping function. Certainly, the to-be-tested function of the target vehicle may be used in different scenarios. For example, the target recognition function of the target vehicle may be tested at night. For example, the target recognition function of the target vehicle is tested in a rainy day, and the target recognition function of the target vehicle is tested in an urban road scenario.

The to-be-tested driving scenario in which the target vehicle travels mainly includes: testing a comprehensive capability of the target vehicle in a scenario. Generally, in a driving scenario, a plurality of functions of the target vehicle need to cooperate with each other to complete a driving task of the vehicle. For example, in a crossroad scenario, if the vehicle needs to safely pass through a crossroad, a traffic light recognition function, an obstacle avoidance function, and a vehicle steering function of the target vehicle need to be tested. In other words, a driving capability of the target vehicle in a specific scenario may be obtained by testing the to-be-tested driving scenario of the target vehicle.

320: Select a first entity from a preset ontology model based on the to-be-tested task, where the ontology model includes a plurality of entities used to describe traffic elements.

There may be one or more first entities. This is not specifically limited in this embodiment of this application.

Optionally, the selecting a first entity based on the to-be-tested task may include: obtaining information used to describe content of the to-be-tested task, where the information includes a first traffic element; and selecting the first entity from the preset ontology model based on the first traffic element, where the first entity is used to describe the first traffic element.

For example, test personnel may enter "follow the vehicle ahead" to describe the content of the to-be-tested task, where the first traffic element may be a "vehicle". In this case, an entity "vehicle entity" corresponding to the first traffic element "vehicle" is selected from the ontology model as the first entity. For another example, the test personnel may enter "drive in the center of the lane line" to describe the content of the to-be-tested task, where the first traffic element may be a "lane line". In this case, the first entity "lane line entity" corresponding to the first traffic element "lane line" is selected from the ontology model. For another example, the test personnel may enter "drive at a crossroad" to describe the content of the to-be-tested task, where the first traffic element may be an "intersection". In this case, the first entity "intersection entity" corresponding to the first traffic element "intersection" is selected from the ontology model.

Certainly, the test personnel may alternatively directly specify the first entity based on the to-be-tested task. A specific manner of obtaining the first entity is not limited in this embodiment of this application.

It should be noted that the information for describing the to-be-tested task may be manually entered by the test personnel, or may be preset in simulation test software and then selected by the test personnel. This is not specifically limited in this embodiment of this application.

In addition, a solution of extracting a keyword from the description of the to-be-tested task may be directly recognized from the description of the to-be-tested task by using an algorithm such as natural language processing (Natural Language Processing, NLP). Alternatively, when the description of the to-be-tested task relates to a key factor of a function or a driving scenario, a corresponding label may be pre-selected for subsequent recognition. A specific method for extracting the keyword based on the description of the to-be-tested task is not limited in this embodiment of this application.

330: Select one or more second entities associated with the first entity from the ontology model based on the first entity and a preset entity association relationship, where the entity association relationship represents a relationship between entities in the ontology model.

The selecting one or more second entities associated with the first entity from the ontology model may include: selecting all entities associated with the first entity from the ontology model as the second entities. However, in this selection manner, a relatively large quantity of second entities are usually selected, which increases a calculation amount and a periodicity of a simulation test. Therefore, in this embodiment of this application, the second entity may be further selected from the ontology model based on a degree of association between entities (that is, an "entity association degree").

That is, step 330 includes: selecting the one or more second entities from the ontology model based on the first entity, the entity association relationship, and a preset entity association degree, where the entity association degree represents a degree of association between entities in the ontology model, a degree of association between each of the one or more second entities and the first entity is higher than a degree of association between another entity in the plurality of entities and the first entity, and the another entity is an entity other than the second entity in the ontology model.

Optionally, a quantity of selected second entities may be limited by setting a quantity of second entities that need to be selected, or by setting an association degree threshold.

For example, the quantity of second entities that need to be selected may be set to 5. In this case, five second entities associated with the first entity are selected from the plurality of entities based on the association relationship between entities and the degree of association between entities. A degree of association between the five second entities and the first entity is higher than the degree of association between another entity in the plurality of entities and the first entity.

For another example, when the second entity is selected by setting the association degree threshold, the method includes: obtaining an association degree threshold based on the to-be-tested task, where the association degree threshold is an association degree threshold used for selecting the one or more second entities from the ontology model; and step 330 includes: creating the one or more second entities in the ontology model based on the first entity, the entity association relationship, and the entity association degree, where the degree of association between the first entity and each of the one or more second entities is higher than the association degree threshold.

It should be noted that each to-be-tested task has a corresponding association degree threshold. The association degree threshold may be specified by the test personnel, or may be preset. This is not limited in this embodiment of this application.

The foregoing entity association degree may be represented by using a specific association degree value, or may be represented by using a distance *N* between entities in a topology view that indicates an association relationship between entities. The distance herein is a minimum quantity of lines that need to pass through when one entity jumps to another entity in the topology view. For example, if two entities are directly connected in the topology view, the distance is 1. For another example, if two entities are separated by one entity, the distance between entities is 2.

Generally, a value of the distance *N* between entities is derived from a test requirement. For example, if only whether a function of the target vehicle is feasible or whether there is an obvious vulnerability needs to be tested, the value of *N* may be 1. Certainly, a larger value of the distance *N* between entities indicates that the to-be-tested task can be tested more comprehensively. That is, a larger value of *N* indicates a larger quantity of entities in a simulation test scenario. Generally, when *N*>5, the selected second entity has no relationship with a type of the to-be-tested task.

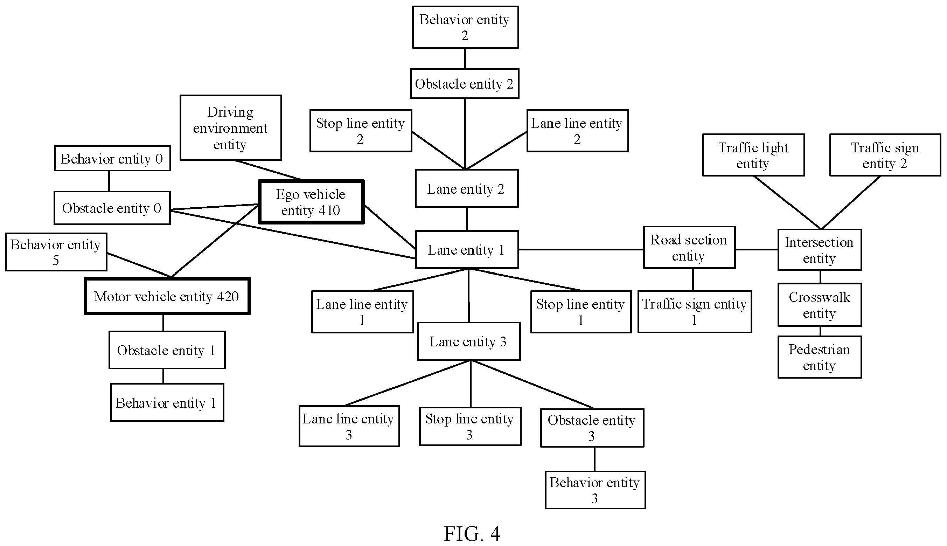

The following describes a process of selecting the second entity by using the association relationship between entities in the ontology model shown in FIG. 4 as an example.

FIG. 4 is a topology view of an association relationship between entities in an ontology model according to an embodiment of this application. Assuming that the to-be-tested task is "follow the vehicle", traffic elements "ego vehicle" and "motor vehicle" may be extracted from the description of the to-be-tested task. Based on this, an ego vehicle entity 410 and a motor vehicle entity 420 may be selected from the ontology model as the first entity, and an entity whose distance from the first entity is 1 needs to be selected as the second entity. It can be learned from the topology view shown in FIG. 4 that a second entity whose distance from the ego vehicle entity 410 is 1 includes a driving environment entity, a motor vehicle entity, and a lane entity 1, and a second entity whose distance from the motor vehicle entity 420 is 1 includes a behavior entity 5 and an obstacle entity 1.

340: Construct, based on the first entity and the one or more second entities, a simulation test scenario used to test the to-be-tested task.

Optionally, step 340 includes: creating a first instance of the first entity and one or more second instances of the one or more second entities in the ontology model based on an attribute of the first entity, an attribute of the second entity, and a relationship between the first entity and the second entity; and constructing the simulation test scenario in the ontology model based on the first instance and the one or more second instances.

It should be noted that the attribute of the first entity, the attribute of the second entity, and the relationship between the first entity and the second entity may be set by the test personnel based on the to-be-tested task, or may directly use a default value in the simulation software. This is not limited in this embodiment of this application.

The foregoing describes the method for constructing a simulation test scenario in embodiments of this application with reference to FIG. 1 to FIG. 4. The solution described above may be used to construct a new simulation test scenario. However, currently, some simulation test software may directly provide a constructed simulation test scenario. Therefore, to avoid reconstructing a simulation test scenario, the method in this application may be further used to update the constructed simulation test scenario. The following provides description with reference to FIG. 4. It should be noted that meanings of terms used in the method shown in FIG. 4 are also the same as those of the foregoing terms. For an obtaining manner, refer to the manner described above. For brevity, details are not described below.

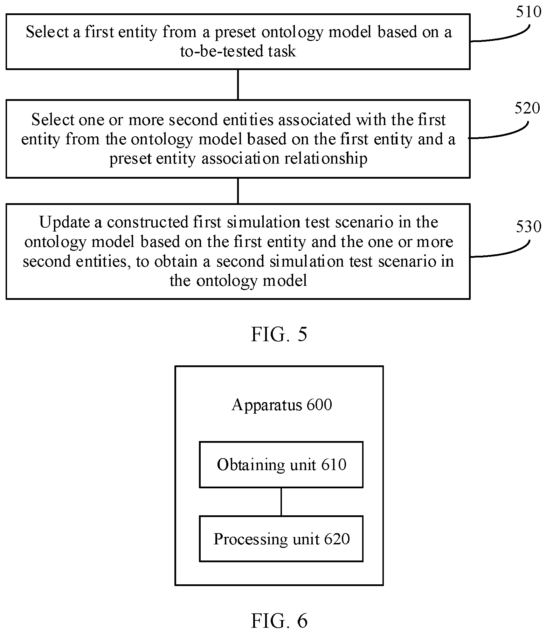

FIG. 5 is a flowchart of a method for constructing a simulation test scenario according to another embodiment of this application. It should be understood that the method shown in FIG. 5 may be performed by the simulation test system shown in FIG. 1, or may be performed by another simulation test device, or may be performed by a computing device having a computing function. This is not specifically limited in this embodiment of this application. The method shown in FIG. 5 includes step 510 to step 530.

510: Select a first entity from a preset ontology model based on a to-be-tested task, where the to-be-tested task is used to indicate to test a to-be-tested function of a target vehicle, and/or test a to-be-tested driving scenario in which the target vehicle travels, and the ontology model includes a plurality of entities used for a traffic element.

520: Select one or more second entities associated with the first entity from the ontology model based on the first entity and a preset entity association relationship.

A manner of selecting the second entity in step 520 is similar to the manner of selecting the second entity in step 330. For brevity, refer to the foregoing descriptions. Details are not described herein again in this application.

530: Update a constructed first simulation test scenario in the ontology model based on the first entity and the one or more second entities, to obtain a second simulation test scenario in the ontology model, where the first simulation test scenario and the second simulation test scenario are simulation test scenarios used to test the to-be-tested task.

The constructed first simulation test scenario may be constructed based on existing simulation test software. Alternatively, the constructed first simulation test scenario may be constructed based on an entity selected by test personnel from the ontology model. A manner of constructing the first simulation test scenario is not limited in this embodiment of this application.

Optionally, step 530 includes: matching entities to which instances in the first simulation test scenario belong against the first entity and the one or more second entities, to determine an entity that is not included in the first simulation test scenario; creating, in the ontology model, an instance corresponding to the entity that is not included; and adding the instance corresponding to the entity that is not included to the first simulation test scenario, to obtain the second simulation test scenario

The creating, in the ontology model, an instance corresponding to the entity that is not included may include: selecting the entity that is not included from the ontology model, and then creating the instance corresponding to the entity by setting an attribute of the entity that is not included and/or a relationship between the entity and another entity.

Optionally, step 530 includes: matching entities in the first simulation test scenario against the first entity and the one or more second entities, to determine a redundant entity other than the first entity and the one or more second entities in the first simulation test scenario; and deleting an instance corresponding to the redundant entity from the first simulation test scenario, to obtain the second simulation test scenario.

The foregoing describes the method in embodiments of this application with reference to FIG. 2 to FIG. 5. The following describes an apparatus in embodiments of this application with reference to FIG. 6 to FIG. 8. It should be noted that the apparatus shown in FIG. 6 to FIG. 8 may implement the steps of the foregoing method. For brevity, details are not described herein again.

FIG. 6 is a schematic diagram of an apparatus for constructing a vehicle simulation test scenario according to an embodiment of this application. The apparatus 600 shown in FIG. 6 includes an obtaining unit 610 and a processing unit 620.

The obtaining unit 610 is configured to obtain a to-be-tested task, where the to-be-tested task is used to indicate to test a function of a target vehicle, and/or test a driving scenario in which the target vehicle travels.

The processing unit 620 is configured to select a first entity from a preset ontology model based on the to-be-tested task, where the ontology model includes a plurality of entities used to describe traffic elements.

The processing unit 620 is further configured to select one or more second entities associated with the first entity from the ontology model based on the first entity and a preset entity association relationship, where the entity association relationship represents a relationship between entities in the ontology model.

The processing unit 620 is further configured to construct, based on the first entity and the one or more second entities, a simulation test scenario used to test the to-be-tested task.

Optionally, in an embodiment, the processing unit 620 is further configured to select the one or more second entities from the ontology model based on the first entity, the entity association relationship, and a preset entity association degree, where the entity association degree represents a degree of association between entities in the ontology model, a degree of association between each of the one or more second entities and the first entity is higher than a degree of association between another entity in the ontology model and the first entity, and the another entity is an entity other than the second entity in the ontology model.

Optionally, in an embodiment, the processing unit 620 is further configured to: obtain an association degree threshold based on the to-be-tested task, where the association degree threshold is an association degree threshold used for selecting the one or more second entities from the ontology model; and select the one or more second entities from the plurality of entities based on the first entity, the entity association relationship, and the entity association degree, where the degree of association between the first entity and each of the one or more second entities is higher than the association degree threshold.

Optionally, in an embodiment, the processing unit 620 is further configured to: create a first instance of the first entity and one or more second instances of the one or more second entities in the ontology model based on an attribute of the first entity, an attribute of the second entity, and a relationship between the first entity and the second entity; and construct the simulation test scenario in the ontology model based on the first instance and the one or more second instances.

Optionally, in an embodiment, the processing unit 620 is further configured to obtain the attribute of the first entity, the attribute of the second entity, and the relationship between the first entity and the second entity.

Optionally, in an embodiment, the processing unit 620 is further configured to: obtain information used to describe content of the to-be-tested task, where the information includes a first traffic element; and selecting the first entity from the preset ontology model based on the first traffic element, where the first entity is used to describe the first traffic element.

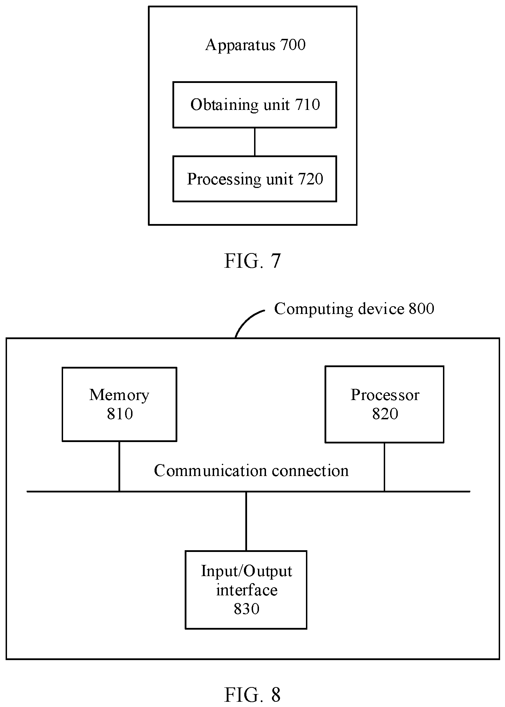

FIG. 7 is a schematic diagram of an apparatus for constructing a vehicle simulation test scenario according to another embodiment of this application. The apparatus 700 shown in FIG. 7 includes an obtaining unit 710 and a processing unit 720.

The obtaining unit 710 is configured to obtain a to-be-tested task, where the to-be-tested task is used to indicate to test a to-be-tested function of a target vehicle, and/or test a to-be-tested driving scenario in which the target vehicle travels.

The processing unit 720 is configured to: select a first entity from a preset ontology model based on the to-be-tested task, where the ontology model includes a plurality of entities used to describe traffic elements; select one or more second entities associated with the first entity from the ontology model based on the first entity and a preset entity association relationship, where the entity association relationship represents a relationship between entities in the ontology model; and update a constructed first simulation test scenario in the ontology model based on the first entity and the one or more second entities, to obtain a second simulation test scenario in the ontology model, where the first simulation test scenario and the second simulation test scenario are simulation test scenarios used to test the to-be-tested task.

Optionally, in an embodiment, the processing unit 720 is further configured to select the one or more second entities associated with the first entity based on the first entity, the entity association relationship, and an entity association degree, where the entity association degree is used to represent a degree of association between entities in the ontology model, a degree of association between each of the one or more second entities and the first entity is higher than a degree of association between another entity and the first entity, and the another entity is an entity other than the second entity in the plurality of entities.

Optionally, in an embodiment, the processing unit 720 is further configured to: match entities to which instances in the first simulation test scenario belong against the first entity and the one or more second entities, to determine an entity that is not included in the first simulation test scenario; create, in the ontology model, an instance corresponding to the entity that is not included; and add the instance corresponding to the entity that is not included to the first simulation test scenario, to obtain the second simulation test scenario.

Optionally, in an embodiment, the processing unit 720 is further configured to: match entities in the first simulation test scenario against the first entity and the one or more second entities, to determine a redundant entity other than the first entity and the one or more second entities in the first simulation test scenario; and delete an instance corresponding to the redundant entity from the first simulation test scenario, to obtain the second simulation test scenario.

In an optional embodiment, the processing unit 620 may be a processor 820, the obtaining unit 610 may be a communications interface 830, and the computing device may further include a memory 810. Details are shown in FIG. 8.

In an optional embodiment, the processing unit 720 may be a processor 820, the obtaining unit 710 may be a communications interface 830, and the computing device may further include a memory 810. Details are shown in FIG. 8.

FIG. 8 is a schematic block diagram of a computing device according to another embodiment of this application. The computing device 800 shown in FIG. 8 may include a memory 810, a processor 820, and a communications interface 830. The memory 810, the processor 820, and the communications interface 830 are connected through an internal connection path. The memory 810 is configured to store instructions. The processor 820 is configured to execute the instructions stored in the memory 820, to control the input/output interface 830 to receive/send at least some parameters of a second channel model. Optionally, the memory 810 may be coupled to the processor 820 through an interface, or may be integrated with the processor 820.

It should be noted that the communications interface 830 implements communication between the communications device 800 and another device or a communications network by using, for example but not limited to, a transceiver apparatus such as a transceiver. The communications interface 830 may further include an input/output interface (input/output interface).

In an implementation process, the steps of the foregoing method may be performed by using an integrated logic circuit of hardware in the processor 820 or instructions in a form of software. The method disclosed with reference to embodiments of this application may be directly performed by a hardware processor, or may be performed by using a combination of hardware and software modules in the processor. The software module may be located in a mature storage medium in the art, such as a random access memory, a flash memory, a read-only memory, a programmable read-only memory, an electrically erasable programmable memory, or a register. The storage medium is located in the memory 810. The processor 820 reads information from the memory 810, and performs the steps of the foregoing method in combination with the hardware of the processor. To avoid repetition, details are not described herein again.

It should be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, may be any conventional processor, or the like.

It should also be understood that in embodiments of this application, the memory may include a read-only memory and a random access memory, and provide an instruction and data to the processor A part of the processor may further include a non-volatile random access memory. For example, the processor may further store information of a device type.

It should be understood that the term "and/or" in this specification describes only an association relationship between associated objects and represents that three relationships may exist. For example, A and/or B may represent the following three cases: Only A exists, both A and B exist, and only B exists. In addition, the character "/" in this specification generally indicates an "or" relationship between the associated objects.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

A person of ordinary skill in the art may be aware that, units and algorithm steps in examples described with reference to embodiments disclosed in this specification can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

A person skilled in the art may clearly understand that, for the purpose of convenient and brief descriptions, for detailed working processes of the foregoing system, apparatus, and unit, refer to corresponding processes in the foregoing method embodiments. Details are not described again herein.

In the several embodiments provided in this application, it should be understood that the disclosed system, apparatus, and method may be implemented in other manners. For example, the described apparatus embodiment is merely an example. For example, division into the units is merely logical function division, and there may be another division manner during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for constructing a vehicle simulation test scenario, comprising:
obtaining a to-be-tested task, wherein the to-be-tested task is used to indicate to test a function of a target vehicle, and/or test a driving scenario in which the target vehicle travels;
selecting a first entity from a preset ontology model based on the to-be-tested task, wherein the ontology model comprises a plurality of entities used to describe traffic elements;
selecting one or more second entities associated with the first entity from the ontology model based on the first entity and a preset entity association relationship, wherein the entity association relationship represents a relationship between entities in the ontology model; and
constructing, based on the first entity and the one or more second entities, a simulation test scenario used to test the to-be-tested task.

2. The method according to claim 1, wherein the selecting one or more second entities associated with the first entity from the ontology model based on the first entity and a preset entity association relationship comprises:
selecting the one or more second entities from the ontology model based on the first entity, the entity association relationship, and a preset entity association degree, wherein the entity association degree represents a degree of association between entities in the ontology model, a degree of association between each of the one or more second entities and the first entity is higher than a degree of association between another entity in the ontology model and the first entity, and the another entity is an entity other than the second entity in the ontology model.

3. The method according to claim 2, wherein before the selecting the one or more second entities from the ontology model based on the first entity, the entity association relationship, and a preset entity association degree, the method further comprises:
obtaining an association degree threshold based on the to-be-tested task, wherein the association degree threshold is an association degree threshold used for selecting the one or more second entities from the ontology model; and
the selecting the one or more second entities from the plurality of entities based on the first entity, the entity association relationship, and a preset degree of association between entities comprises:
selecting the one or more second entities from the ontology model based on the first entity, the entity association relationship, and the entity association degree, wherein the degree of association between the first entity and each of the one or more second entities is higher than the association degree threshold.

4. The method according to any one of claims 1 to 3, wherein the constructing, based on the first entity and the one or more second entities, a simulation test scenario used to test the to-be-tested task comprises:
creating a first instance of the first entity and one or more second instances of the one or more second entities in the ontology model based on an attribute of the first entity, an attribute of the second entity, and a relationship between the first entity and the second entity; and
constructing the simulation test scenario in the ontology model based on the first instance and the one or more second instances.

5. The method according to claim 4, wherein before the creating a first instance of the first entity and one or more second instances of the one or more second entities in the ontology model based on an attribute of the first entity, an attribute of the second entity, and a relationship between the first entity and the second entity, the method further comprises:
obtaining the attribute of the first entity, the attribute of the second entity, and the relationship between the first entity and the second entity.

6. The method according to any one of claims 1 to 5, wherein the selecting a first entity from a preset ontology model based on the to-be-tested task comprises:
obtaining information used to describe content of the to-be-tested task, wherein the information comprises a first traffic element; and
selecting the first entity from the preset ontology model based on the first traffic element, wherein the first entity is used to describe the first traffic element.

7. An apparatus for constructing a vehicle simulation test scenario, comprising:
an obtaining unit, configured to obtain a to-be-tested task, wherein the to-be-tested task is used to indicate to test a function of a target vehicle, and/or test a driving scenario in which the target vehicle travels; and
a processing unit, configured to select a first entity from a preset ontology model based on the to-be-tested task, wherein the ontology model comprises a plurality of entities used to describe traffic elements, wherein
the processing unit is further configured to select one or more second entities associated with the first entity from the ontology model based on the first entity and a preset entity association relationship, wherein the entity association relationship represents a relationship between entities in the ontology model; and
the processing unit is further configured to construct, based on the first entity and the one or more second entities, a simulation test scenario used to test the to-be-tested task.

8. The apparatus according to claim 7, wherein the processing unit is further configured to:
select the one or more second entities from the ontology model based on the first entity, the entity association relationship, and a preset entity association degree, wherein the entity association degree represents a degree of association between entities in the ontology model, a degree of association between each of the one or more second entities and the first entity is higher than a degree of association between another entity in the ontology model and the first entity, and the another entity is an entity other than the second entity in the ontology model.

9. The apparatus according to claim 8, wherein the processing unit is further configured to:
obtain an association degree threshold based on the to-be-tested task, wherein the association degree threshold is an association degree threshold used for selecting the one or more second entities from the ontology model; and
select the one or more second entities from the ontology model based on the first entity, the entity association relationship, and the entity association degree, wherein the degree of association between the first entity and each of the one or more second entities is higher than the association degree threshold.

10. The apparatus according to any one of claims 7 to 9, wherein the processing unit is further configured to:
create a first instance of the first entity and one or more second instances of the one or more second entities in the ontology model based on an attribute of the first entity, an attribute of the second entity, and a relationship between the first entity and the second entity; and
construct the simulation test scenario in the ontology model based on the first instance and the one or more second instances.

11. The apparatus according to claim 10, wherein the processing unit is further configured to:
obtain the attribute of the first entity, the attribute of the second entity, and the relationship between the first entity and the second entity.

12. The apparatus according to any one of claims 7 to 11, wherein the processing unit is further configured to:
obtain information used to describe content of the to-be-tested task, wherein the information comprises a first traffic element; and
select the first entity from the preset ontology model based on the first traffic element, wherein the first entity is used to describe the first traffic element.

13. A computing device, comprising at least one processor and a memory, wherein the at least one processor is coupled to the memory, and is configured to read and execute instructions in the memory, to perform the method according to any one of claims 1 to 6.

14. A computer-readable medium, wherein the computer-readable medium stores program code, and when the computer program code is run on a computer, the computer is enabled to perform the method according to any one of claims 1 to 6.

15. A chip, comprising at least one processor and a memory, wherein the at least one processor is coupled to the memory, and is configured to read and execute instructions in the memory, to perform the method according to any one of claims 1 to 6.
